Europäisches Patentamt

(19) European Patent Office

Office européen des brevets

(11) Publication number:

**0 071 559**
**B1**

(12) **EUROPEAN PATENT SPECIFICATION**

(45) Date of publication of patent specification: **08.10.86**

(21) Application number: **82630072.5**

(22) Date of filing: **19.07.82**

(51) Int. Cl.⁴: **H 05 K 7/14**

(54) **Fastener of the hold-down type.**

(30) Priority: **28.07.81 US 287613**

(43) Date of publication of application:
**09.02.83 Bulletin 83/06**

(45) Publication of the grant of the patent:
**08.10.86 Bulletin 86/41**

(84) Designated Contracting States:
**DE FR GB IT**

(56) References cited:
**CH-A- 246 334**
**DE-A-1 800 200**
**DE-B-2 112 587**
**FR-A-2 114 451**
**US-A-2 901 279**
**US-A-3 316 456**
**US-A-3 432 197**
**US-A-3 734 444**
**US-A-3 872 734**
**US-A-4 018 091**

(73) Proprietor: **REXNORD INC.**
**P.O. Box 2022**
**Milwaukee, Wisconsin 53201 (US)**

(72) Inventor: **Cosenza, Frank J.**
**1524 West Fifth Street**
**San Pedro California 90732 (US)**

(74) Representative: **Weydert, Robert et al**
**Office Dennemeyer S.à.r.l. 21-25 Allée Scheffer**
**P.O. Box 41**
**L-2010 Luxembourg (LU)**

(56) References cited:

**IBM TECHNICAL DISCLOSURE BULLETIN Vol.**
**22, No. 4, September 1979, New York J.A.**
**DICKERSON et al. "Latching Mechanism" pages**
**1580 to 1581**

**"Soviet Inventions Illustrated" Week C 20, 25**
**June 1980 Section Q 61**

## Description

The present invention relates to a hold-down type fastener device for use in selectively displacing and securing a unit mounted on a frame structure under a predetermined load, comprising a shaft at least a portion of which is threaded, said shaft having one end thereof adapted to receive a pivot pin, an annular cylindrical keeper adapted to engage a hook member extending from the unit to be displaced and secured by the fastener device, said keeper surrounding said shaft and being axially movable with respect thereto, drive means mounted on said shaft for moving said keeper axially with respect to said shaft, said drive means comprising a hollow hub member engaging the threaded portion of said shaft for rotational and axial movement with respect thereto, a drive sleeve mounted on and coupled to said hub member, load limiting clutch means between the drive sleeve and the hub member, and spring means for transmitting axial motion from said hub member to said keeper. A fastener device of this type is known from DE—B—2 112 587.

With the advent of light weight and miniaturized electronic components, the aircraft industry has developed modular electronic units which can be readily inserted and removed from support structure built into the aircraft. Repairs can thus be made to units at facilities removed from the aircraft. To facilitate quick removal and replacement of such units, various types of fastening devices are employed. All of the fastening devices firmly secure the units to the support structure. From US—A—3 640 141, 3 872 734 and 4 018 091 and the above mentioned DE—A—2 112 587 fastening devices are known which additionally serve to displace the unit to and from the operable seated position within the frame structure.

A continued problem plaguing the aircraft industry is the paramount need to reduce the weight of the aircraft. As the cost of aviation fuel increases, the economic pressure exerted on the industry continues to mount necessitating critical analysis of the various aircraft parts to determine where weight savings can be made. The prior art fastener devices mentioned above while functioning admirably would be much more acceptable if some weight reduction could be accomplished without sacrifice to quality or function of the parts.

In DE—B—2 112 587 referred to herein a separate helical spring is provided for urging the keeper against a stop formed on a retractor element. To permit engagement of the keeper with the hook the keeper must be manually retracted against the helical spring.

US—A—3 640 141 shows a two-part keeper comprised of a carriage having a cup portion pivotally mounted therein. The cup portion has a handle extending outwardly through a transverse groove formed in the carriage. The cup portion is adapted to be pivoted over the hook fixed to the device to be secured.

US—A—3 872 734 and 4 018 091 are not concerned with a fastener device of the type described above comprising slip-clutch means and spring means operatively interposed between the drive sleeve and the keeper.

In accordance with the invention the hold down type fastener device is characterized in that the end of the keeper facing away from the sleeve has surface (hereinafter called ramp surface) inclined with respect to a plane perpendicular to the axis of the shaft, whereby the keeper has an axially short part and an axially long part, the axially short part having a first slot therein and the axially long part having a second slot therein, the first slot extending to a deeper location into the keeper than the second slot, said keeper being rotatable from a first position wherein the hook member is adapted to be received in the first slot to a second position wherein the hook member is adapted to be received in the second slot, camming action between the ramp surface and the hook member during rotation of the keeper from the first to the second position urging the keeper axially toward the drive sleeve against the force of the spring means.

In use, when the keeper abuts the hook of the module unit relative longitudinal movement occurs between the sleeve and keeper when the sleeve is rotated in a direction toward a locked or loaded position. Cessation of the relative longitudinal movement indicates that a predetermined load is being approached and free rotation of the sleeve indicates that the predetermined load has been reached.

An extractor element may also be mounted on the shaft and is fixed relative to the longitudinal movement of the keeper. The extractor element functions to displace the unit away from its seated position as the sleeve is rotated in a counter-clockwise direction.

A more thorough understanding of the present invention will be gained by reading the following description of the preferred embodiments with reference to the accompanying drawings, in which:

Figure 1 is perspective view of a module unit fastened with fasteners of the present invention.

Figure 2 is an isometric view illustrating the connection of the fastener shaft to the supporting structure.

Figure 3 is an enlarged side-sectional view of the fastener of the present invention.

Figure 4 is a side-sectional view of the fastener of the present invention in its unlocked position.

Figure 5 is a side-sectional view of the fastener of the present invention in its locked or loaded position.

Figure 6a is an isometric view of the fastener in a free position.

Figure 6b is a top view of the fastener of Figure 6a.

Figure 6c is a bottom view of the fastener of Figure 6a.

Figure 7 is still another isometric view of the fastener of the present invention when translated to a position adjacent the hook element.

Figure 8 illustrates an isometric view of the fastener in the position depicted by Figure 7 about to be secured to the hook element.

Figure 9 illustrates isometrically the fastener when secured to the hook element prior to its loaded position.

Figure 10 illustrates isometrically the fastener when in its loaded position.

Figure 11 is an isometric view of the fastener when in its extracted position.

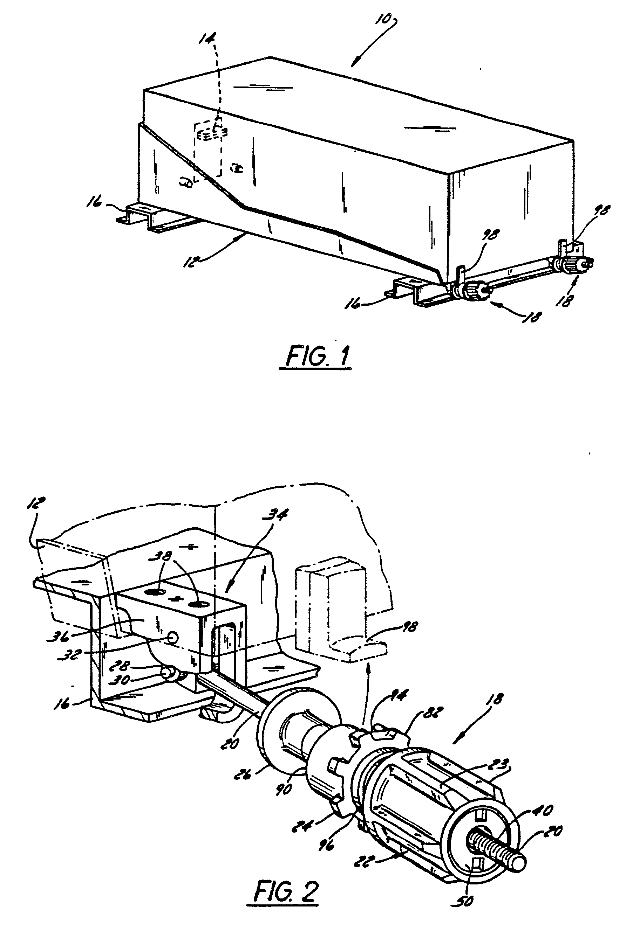

The perspective drawing of Figure 1 generally illustrates a modular unit 10 of any function which is adapted to be positioned on a support shelf 12. When in its seated position, unit 10 receives electrical connectors 14 shown in phantom which permits unit 10 to become functional. Shelf 12 is shown supported by two cross members 16, shown strictly for illustrative purposes, as the type of supporting structure is purely arbitrary and forms no part of the present invention.

Attached to the shelf are paired swing fasteners 18 which, as will be discussed, serve to secure unit 10 to shelf 12 in the seated position and displace the unit to and from the seated position. The precise number of swing fasteners used to hold a unit is a matter of choice, but is traditionally two as shown.

Figure 2 perhaps best illustrates the major exterior components of fastener 18. Each fastener 18 comprises a shaft 20 about which is mounted a rotatable sleeve 22, a freely rotating keeper 24, and an extractor 26. Shaft 20 is pivotably connected to link 28 by pin 30. Link 28 is pivotally connected via pin 32 to the side walls 36 of fixed element 34 in turn secured by bolts 38 to the under surface of shelf 12.

Sleeve 22 is provided with a plurality of longitudinally running splines 23 which facilitate manual gripping of sleeve 22. However, any friction inducing material may be employed as well.

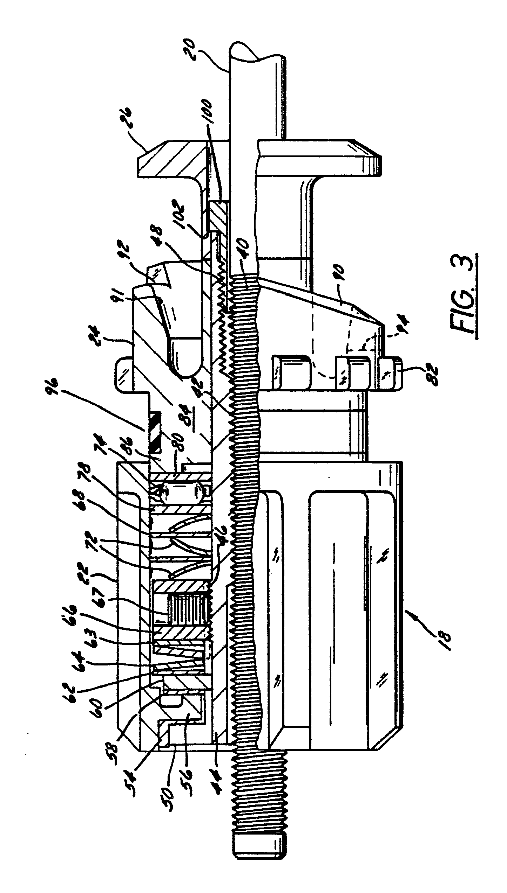

Figure 3, in side section, depicts the details of the clutch and spring arrangement. Central shaft 20 has threads 40 and is complementary to and receives threads 42 of hollow central hub or drive shaft 44. Shaft 44 has two additional threaded portions 46 and 48 for purposes to be discussed. Head 50 of shaft 44 abuts a wear cup 54 which in turn are fitted against annular projection 56 of sleeve 22. The opposite surface of projection 56 is positioned against the slip-clutch assembly comprised of clutch 58, clutch plate 60, and washer 62.

Behind washer 62 is positioned one or more belleville washers 64 and a washer 63. A threaded disc or adjustor 66 is located on the opposite side of washer 63. Adjustor 66 which can be rotated along threads 46 of shaft 44 permits preload adjustment to washers 64 to insure the necessary load requirements are met. To prevent any inadvertent rotation of adjustor 66, a set screw 67 locked into shaft 44 is located on the adjustor 66. Adjacent to adjustor 66 are a series of curved washers 72, disc washers 68, and thrust bearing 74, positioned between two plates 78, 80 which during operation deflect keeper 24 rearward until it firmly abuts the module. Curved washers 72 are compressible and permit keeper 24 to move relative to and glide inside of sleeve 22.

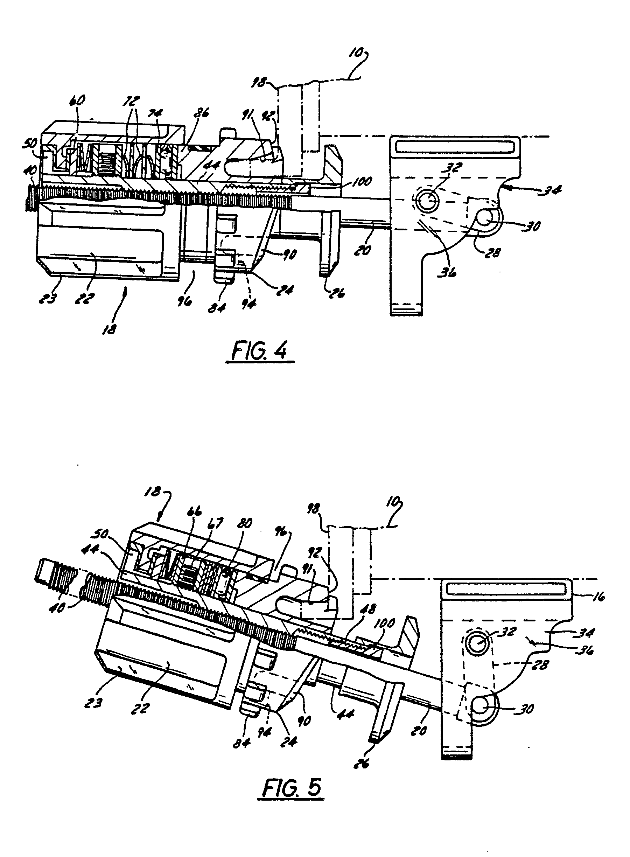

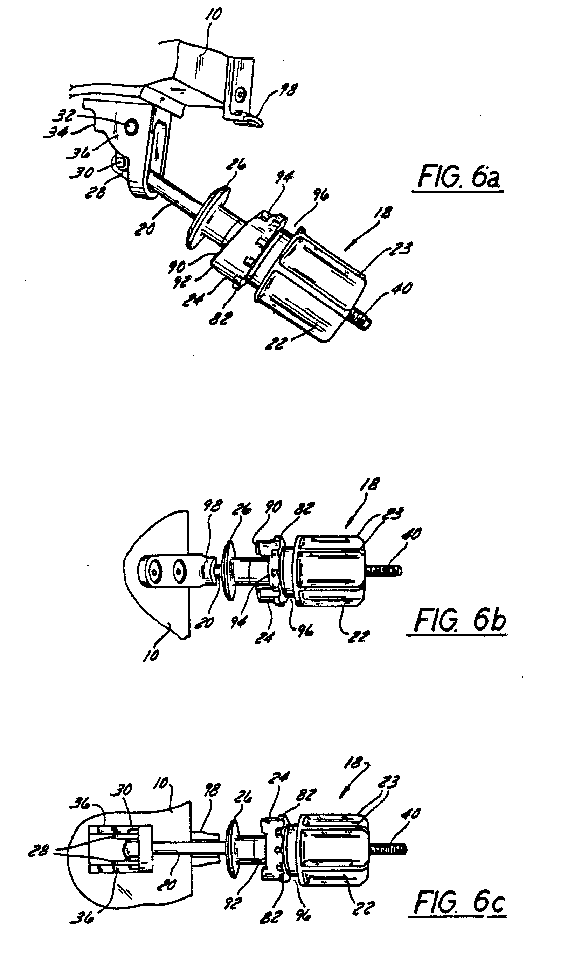

Figures 4 and 5 respectively show the fastener 18 in partial side section when still attached to unit 10 but in an unloaded condition and when in its loaded condition. It should be noted that in the loaded condition curved washers 72 are compressed. This and other relationships will be discussed in connection with the operation of fastener 18 to be described. The sidewalls 36 of element 34 are integral and do form a U-shaped section facing fastener 18. Additionally walls 36 are cut away to permit unimpeded movement of link 28 and pin 30.

Reference is now made to Figure 3 and then to Figures 6—10 which illustrate sequentially the operation of fastener unit 18 with particular emphasis on the advantageous function of keeper 24. The isometric view of Figure 6a displays unit 18 in its free state with shaft 20 resting against the U-shaped curvature of element 34. Keeper 24 takes the general form of an annular cylinder which is positioned on and freely rotates about shaft 44. A raised ring or knob 82 accommodates manual rotation of keeper 24.

As seen in Figure 3, region 84 of keeper 24 contacts plate 80 along an extension 86. The small area contact removed from shaft 44 ensures the load (resulting when fastener 18 is secured) is passed to shaft 44 along the longest moment arm possible. Also in Figure 3, it should be noticed that extractor 26 abuts keeper 24 and is partly maintained in such a relationship by threaded tubular nut 100 which is threadedly engaged with central shaft 44 along threads 48. The head of nut 100 abuts a small downward projecting ledge 102 of extractor 26. When nut 100 is tightly threaded into position, the abutting relationship with ledge 102 normally maintains the contact between extractor 26 and keeper 24 except, as described below, when fastener 18 is in its secured or fastened position.

The end of keeper 24 as shown in Figure 6a facing away from sleeve 22 has a frusto-cylindrical shape which provides a ramp surface 90 which, as described below, serves as a cam in the operation of unit 18.

Figures 6b and 6c illustrate, respectively, the top and bottom view of fastener 18 of Figure 6a still in the free state. As can be seen in Figure 6b, a slot 94 is positioned appropriately to receive hook 98. Diametrically opposed to slot 94 is a second slot 92 cut into the extended portion of ramp surface 90 as seen in Figure 6c. Slot 92, however, does not extend as deep as slot 94 for an important reason stated below.

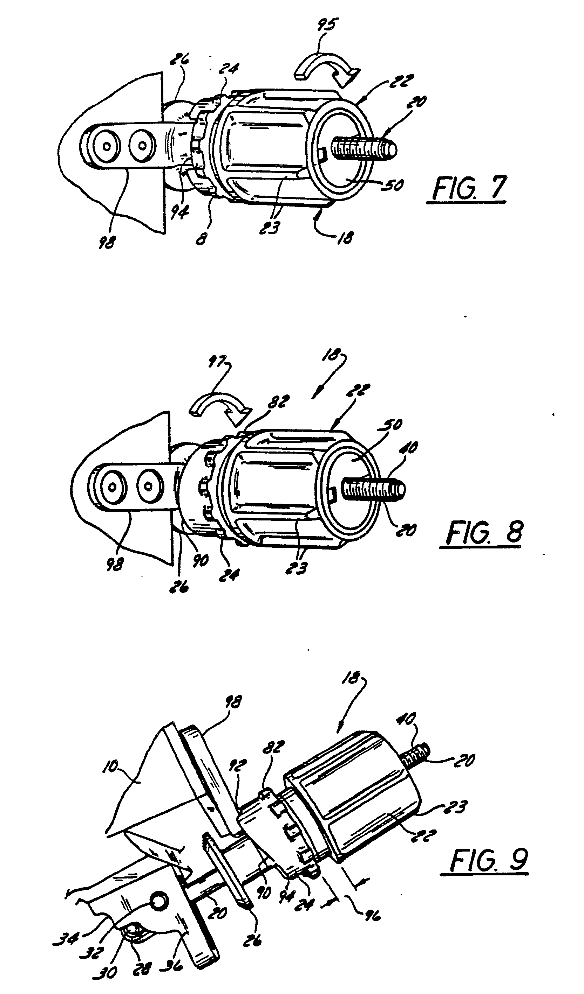

When sleeve 22 is rotated clock-wise, as illustrated by arrow 95, keeper 24 is translated to the position indicated in Figure 7. At this position slot 94 and hook 98 are in a proper relationship for engagement through either clock-wise or counter clock-wise rotation of keeper 24. This rotation, shown to be clock-wise in Figure 8 by arrow 97 causes ramp surface 90 to ride against hook 98. As keeper 24 is rotated into position, curved spring washers 72 deflect under the camming action of surface 90. Gap 96 shown at its maximum width in Figure 9 becomes narrower and reaches a reduced width just prior to engagement of hook 98 and slot 92. When hook 98 snaps into slot 92, gap 96 again increases. At this position, there is also a small clearance between extractor 26 and the backside of hook 98.

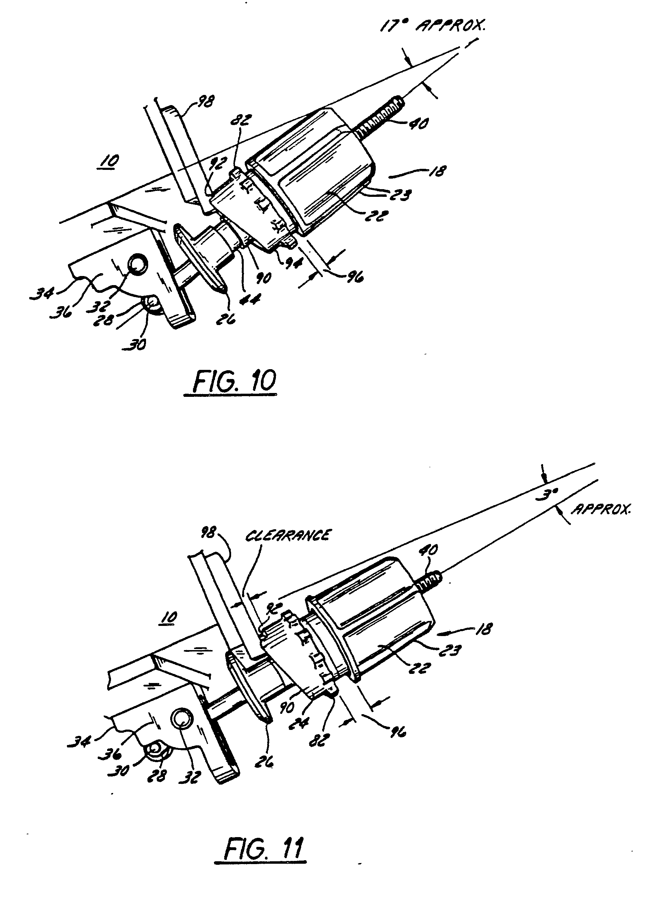

As sleeve 22 is rotated further, keeper 24 begins to exert an increasing load against hook 98. If unit 10 is not positioned properly on supporting shelf 12, the rotation of sleeve 22 causes unit 10 to move into a position in which unit 10 becomes connected to electrical connectors 14. Further rotation of the sleeve causes gap 96 to decrease again and pin 30 of link to abut the underside of latch as most clearly depicted in the isometric view of Figure 10. In this position the axis of fastener 18 is inclined at about an angle of 17° with the horizontal plane due to the angle that the bearing surface 91 makes with the horizontal plane. At this position, fastener 18 is at its predetermined load limit. Any further rotation of sleeve 22 will cause the slip clutch assembly to become operative to prevent further increase in load and damage to the fastener.

If desired a band of brightly covered material may be placed around the surface of keeper 24 in gap 96. As sleeve 22 moves over keeper 24, the disappearance of the material indicates the approach of a lockable position.

When it is desired to extract unit 10 from shelf 12, sleeve 22 is rotated counter-clockwise. The clutch is instantly engaged, resulting in a positive driving action allowing sleeve 22 to move relative to shaft 44 for a short distance. Then shaft 4 having an abutting relationship with ledge 102 of extractor 26 causes extractor 26 to move toward the backside of hook 98, to abut the same, and then displace unit 10 from its seated position, disconnecting it from connectors 14. As can be seen in Figure 11, gap 96 is returned to its maximum position. Additionally the angle of incline of fastener 18 with the horizontal is reduced to about 3° because of movement link 28 and pin 30 to position shown. Fastener 18 then can be released to its free state by pulling back on keeper 24 and rotating it in either direction to line up slot 94 with hook 98. At this point, the unit will drop away into its free state.

## Claims

1. Hold down type fastener device for use in selectively displacing and securing a unit mounted on a frame structure under a predetermined load, comprising a shaft (20) at least a portion of which is threaded, said shaft having one end thereof adapted to receive a pivot pin, an annular cylindrical keeper (24) adapted to engage a hook member (98) extending from the unit to be displaced and secured by the fastener device, said keeper (24) surrounding said shaft (20) and being axially movable with respect thereto, drive means mounted on said shaft (20) for moving said keeper (24) axially with respect to said shaft (20), said drive means comprising a hollow hub member (44) engaging the threaded portion of said shaft (20) for rotational and axial movement with respect thereto, a drive sleeve (22) mounted on and coupled to said hub member (44), load limiting clutch means (58) between the drive sleeve (22) and the hub member (44), and spring means (72) for transmitting axial motion from said hub member (44) to said keeper (24), characterized in that the end of the keeper (24) facing away from the sleeve (22) has a surface (90) inclined with respect to a plane perpendicular to the axis of the shaft, whereby the keeper has an axially short part and an axially long part, the axially short part having a first slot (94) therein and the axially long part having a second slot (92) therein, the first slot (94) extending to a deeper location into the keeper (24) than the second slot (92), said keeper (24) being rotatable from a first position wherein the hook member (98) is adapted to be received in the first slot (94) to a second positon wherein the hook member (98) is adapted to be received in the second slot (92), camming action between the inclined surface (90) and the hook member (96) during rotation of the keeper (24) from the first to the second position urging the keeper (24) axially toward the drive sleeve (22) against the force of the spring means (72).

2. The hold-down type fastener device according to claim 1, characterized in that said keeper (24) is constructed and arranged for rotation in a first direction and in a second opposite direction with the hook member (98) being partially covered by said keeper (24).

3. Hold down type fastener device according to claim 1 or 2, characterized in that said keeper (24) has a bearing surface (91) inside said keeper axially long part, said bearing surface (91) being inclined at a pre-determined angle with a horizontal plane and arranged to bear against the hook member (98).

4. Hold down type fastener device according to any one of claims 1 to 3, characterized in that the hub member (44) comprises an elongated hollow shaft member, said keeper (24) surrounding said shaft member (44) and having one end thereof received inside said drive sleeve (22).

5. Hold down type fastener device according to claim 4, characterized in that said end of the keeper (24) received inside said drive sleeve (22) comprises a load transmitting extension (86) radially spaced from the hollow shaft member (44).

6. Hold down type fastener device according to claim 4 or 5, characterized in that the keeper (24) comprises a raised portion (82), and that a gap (96) is formed between said keeper raised portion (82) and said drive sleeve (22), said gap being of maximum width when the hold down device is an unloaded position and of minimum width when it is in a fully loaded position.

7. Hold down type fastener device according to claim 6, characterized in that a band of brightly covered material is formed on said keeper to indicate approach of the fully loaded position when received in the drive sleeve (22).

8. Hold down type fastener device according to any one of claims 1 to 7, characterized in that means are provided for adjusting the preload on the load limiting clutch means (58).

9. Hold down type fastener device according to claim 8, characterized in that the adjusting means comprises a disc member (66) adjustably mounted on the hub member (44) to adjust the preload of spring washers (64) interposed between the load limiting clutch means (58) and the disc member on one side thereof.

10. Hold down type fastener device according to claim 9, characterized in that the spring means (72) are curved spring washers located on the other side of the adjustable disc member (66).

11. Hold down type fastener device according to any one of claims 1 to 10, characterized in that a thrust bearing (74) is provided between the spring means (72) and the keeper (24).

12. Hold down type fastener device according to any one of claims 1 to 11, characterized in that one end of a link (28) is pivotably connected to said one end of the shaft (20), the other end of said link (28) being adapted to be pivotably connected to a fixed element (34) secured to the frame structure.

**Revendications**

1. Dispositif de fixation du type hold down utilisable pour déplacer et bloquer sélectivement, sous une charge prédéterminée, une unité monté sur une structure de châssis support, comprenant un arbre (20) dont une portion au moins est filetée, cet arbre ayant une extrémité adaptée de manière à recevoir un axe de pivotement, une bague de maintien cylindrique annulaire (24) adaptée de manière à venir en contact avec un crochet (98) s'étendant à partir de l'unité devant être déplacée et bloquée par le dispositif de fixation, cette bague de maintien (24) entourant l'arbre (20) et étant mobile axialement par rapport à celui-ci, un dispositif d'entraînement monté sur l'arbre (20) pour déplacer axialement la bague de maintien (24) par rapport à l'arbre (24), ce dispositif d'entraînement comprenant un moyeu creux (44) engagé sur la partie filetée de l'arbre (20) afin d'effectuer un mouvement de rotation et un mouvement axial par rapport à ce dernier, une douille d'entraînement (22) montée sur le moyeu (44) et accouplée à celui-ci, un embrayage limiteur de charge (58) entre la douille d'entraînement (22) et le moyeu (44), et des moyens élastiques (72) pour transmettre le mouvement axial à partir du moyeu (44) à la bague de maintien (24), caractérisé en ce que la partie frontale de la bague de maintien (24) qui est située à l'opposé de la douille (22), présente une surface (90) inclinée par rapport à un plan perpendiculaire à l'axe de l'arbre, si bien que la bague de maintien comprend une partie courte dans le sens axial et une partie longue dans le sens axial, la partie courte dans le sens axial comportant une première encoche (94) tandis que la partie longue dans le sens axial romporte une seconde encoche (92), la première encoche (94) s'étendant jusqu'à un emplacement plus profond dans la bague de maintien (24) que la seconde encoche (92), la bague de maintien (24) pouvant tourner à partir d'une première position dans laquelle le crochet (98) est adapté de manière à venir se loger dans la première encoche (94), jusqu'à une seconde position dans laquelle le crochet (98) peut venir se loger dans la seconde encoche (92), l'action de came s'exerçant entre la surface inclinée (90) et le crochet (96) pendant la rotation de la bague de maintien (24) de la première à la seconde position sollicitant cette bague de maintien (24) axialement en direction de la douille d'entraînement (22), à l'encontre de la force des moyens élastiques (72).

2. Dispositif de fixation du type hold down suivant la revendication 1 caractérisé en ce que la bague de maintien (24) est construite et disposée de manière à pouvoir tourner dans une première direction et dans une seconde direction opposée la précédente, la crochet (98) étant partiellement recouvert par la bague de maintien (24).

3. Dispositif de fixation du type hold down suivant l'une quelconque des revendications 1 ou 2 caractérisé en ce que la bague de maintien (24) comporte une surface d'appui (91) à l'intérieur de la partie longue, dans le sens axial, de la bague de maintien, cette surface d'appui (91) étant inclinée d'un angle prédéterminé par rapport à un plan horizontal et étant disposée de manière à porter contre le crochet (98).

4. Dispositif de fixation du type hold down suivant l'une quelconque des revendications 1 à 3 caractérisé en ce que le moyeu (44) est constitué par un arbre creux allongé, la bague de maintien (24) entourant cet arbre creux (44) et ayant une extrémité logée à l'intérieur de la douille d'entraînement (22).

5. Dispositif de fixation du type hold down suivant la revendication 4 caractérisé en ce que ladite extrémité de la bague de maintien (24) logée à l'intérieur de la douille d'entraînement (22) comprend une saillie de transmission de charge (86) qui est espacée radialement de l'arbre creux (44).

6. Dispositif de fixation du type hold down suivant l'une quelconque des revendications 4 ou 5 caractérisé en ce que la bague de maintien (24) comprend une portion en saillie (82) et un intervalle (96) est formé entre cette portion en saillie (82) de la bague de maintien et la douille d'entraînement (22), cet intervalle ayant une largeur maximale lorsque le dispositif de fixation est dans la position non chargée et une largeur minimale lorsqu'il se trouve dans une position totalement chargée.

7. Dispositif de fixation du type hold down suivant la revendication 6 caractérisé en ce qu'une bande d'un matériau brillant est formée sur la bague de maintien (24) afin d'indiquer l'approche de la position totalement chargée lorsqu'elle vient se loger dans la douille de maintien (22).

8. Dispositif de fixation du type hold down suivant l'une quelconque des revendications 1 à 7 caractérisé en ce que des moyens sont prévus pour ajuster la pécontrainte de l'embrayage limiteur de charge (58).

9. Dispositif de fixation du type hold down suivant la revendication 8 caractérisé en ce que les moyens d'ajustement de la précontrainte comprennent un disque (66) monté d'une manière réglable sur le moyeu (44), afin d'ajuster la précontrainte de rondelles élastiques (64) interposées entre l'embrayage limiteur de charge (58) et le disque, sur un côté de celui-ci.

10. Dispositif de fixation du type hold down suivant la revendication 9 caractérisé en ce que les moyens élastiques (72) sont constitués par des rondelles élastiques courbes disposées de l'autre côté du disque réglable (66).

11. Dispositif de fixation du type hold down suivant l'une quelconque des revendications 1 à 10 caractérisé en ce qu'un palier axial (74) est prévu entre les moyens élastiques (72) et la bague de maintien (24).

12. Dispositif de fixation du type hold down suivant l'une quelconque des revendications 1 à 11 caractérisé en ce qu'une extrémité d'une bielle (28) est articulée sur la première extrémité de l'arbre (20) tandis que l'autre extrémité de la bielle (28) est adaptée de manière à pouvoir pivoter sur un élément fixe (34) fixé à la structure du châssis porteur.

**Patentansprüche**

1. Niederhaltevorrichtung zur Verwendung beim wahlweisen Verschieben und Befestigen einer Einheit, die auf einer Rahmenvorrichtung unter einer vorbestimmten Belastung befestigt ist, mit einer Spindel (20), von welcher wenigstens ein Teil mit Gewinde versehen ist, wobei ein Ende der Spindel einen Drehzapfen aufnehmen kann, mit einer ringförmigen, zylindrischen Schiebehülse (24) zum Erfassen eines Hakenteils (98), das an der Einheit vorgesehen ist, die durch die Niederhaltevorrichtung zu verschieben und zu befestigen ist, wobei die Schiebehülse (24) die Spindel (20) umgibt und in bezug auf diese axial bewegbar ist, mit einer auf der Spindel (20) befestigten Antriebseinrichtung zum axialen Bewegen der Schiebehülse (24) in bezug auf die Spindel (20), wobei die Antriebseinrichtung ein hohles Nabenteil (44) aufweist, das mit dem Gewindeteil der Spindel (20) zur Dreh- und Axialbewegung in bezug auf diese in Eingriff ist, mit einer Antriebshülse (22), die auf dem Nabenteil (44) befestigt und mit diesem verbunden ist, mit einer lastbegrenzenden Kupplungseinrichtung (58) zwischen der Antriebshülse (22) und dem Nabenteil (44) und mit einer Federeinrichtung (72) zum Übertragen der Axialbewegung von dem Nabenteil (44) auf die Schiebehülse (24), dadurch gekennzeichnet, daß das Ende der Schiebehülse (24), das von der Antriebshülse (22) abgewandt ist, eine Oberfläche (90) hat, die in Bezug auf eine zu der Achse der Spindel rechtwinkelige Ebene geneigt, ist, wodurch die Schiebehülse einen axial kurzen Teil und einen axial langen Teil hat, von denen der axial kurze Teil einen ersten Schlitz (94) und der axial lange Teil einen zweiten Schlitz (92) aufweist, wobei sich der erste Schlitz (94) bis zu einer tieferen Stelle in die Schiebehülse (24) erstreckt als der zweite Schlitz (92), daß die Schiebehülse (24) aus einer ersten Position, in der das Hakenteil (98) in dem ersten Schlitz (94) aufnehmbar ist, in eine zweite Position drehbar ist, in der das Hakenteil (98) in dem zweiten Schlitz (92) aufnehmbar ist, und daß durch Nockenwirkung zwischen der geneigten Oberfläche (90) und dem Hakenteil (96) während der Drehung der Schiebehülse (24) aus der ersten in die zweite Position die Schiebehülse (24) gegen die Kraft der Federeinrichtung (72) axial zu der Antriebshülse (22) gedrückt wird.

2. Niederhaltevorrichtung nach Anspruch 1, dadurch gekennzeichnet, daß die Schiebehülse (24) zur Drehung in einer ersten Richtung und in einer zweiten, entgegengesetzten Richtung ausgebildet und angeordnet ist, wobei das Hakenteil (98) durch die Schiebehülse (24) teilweise bedeckt ist.

3. Niederhaltevorrichtung nach Anspruch 1 oder 2, dadurch gekennzeichnet, daß die Schiebehülse (24) eine tragende Fläche (91) innerhalb des axial langen Teils der Schiebehülse hat und daß die tragende Fläche (91) unter einem vorbestimmten Winkel gegen eine Horizontalebene geneigt und so angeordnet ist, das sie an dem Hakenteil (98) trägt.

4. Niederhaltevorrichtung nach einem der Ansprüche 1 bis 3, dadurch gekennzeichnet, daß das Nabenteil (44) ein langgestrecktes hohles Schaftteil ist und daß die Schiebehülse (24) das Schaftteil (44) umgibt und mit einem Ende in der Antriebshülse (22) aufgenommen ist.

5. Niederhaltevorrichtung nach Anspruch 4, dadurch gekennzeichnet, daß das Ende der Schiebehülse (24), das in der Antriebshülse (22) aufgenommen ist, einen lastübertragenden Fortsatz (86) aufweist, der radialen Abstand von dem hohlen Schaltteil (44) hat.

6. Neiderhaltevorrichtung nach Anspruch 4 oder 5, dadurch gekennzeichnet, daß die Schiebehülse (24) einen erhöhten Teil (82) aufweist und das ein Spalt (96) zwischen dem erhöhten Teil (82) der Schiebehülse und der Antriebshülse (22) gebildet ist, wobei der Spalt eine maximale Breite hat, wenn die Niederhaltevorrichtung in einem unbelasteten Zustand ist, und eine minimale Breite, wenn sie in einem voll belasteten Zustand ist.

7. Niederhaltevorrichtung nach Anspruch 6, dadurch gekennzeichnet, daß ein Band aus hell bedecktem Material an der Schiebehülse vorgesehen ist, um die Annäherung an die voll belastete Position anzuzeigen, wenn sie in der Antriebshülse (22) aufgenommen ist.

8. Niederhaltevorrichtung nach einem der Ansprüche 1 bis 7, dadurch gekennzeichnet, daß Einrichtungen zum Einstellen der Vorbelastung an der lastbegrenzenden Kupplungseinrichtung (58) vorgesehen sind.

9. Niederhaltevorrichtung nach Anspruch 8, dadurch gekennzeichnet, daß die Enstelleinrichtungen ein Scheibenteil (66) aufweisen, das auf dem Nabenteil (44) einstellbar befestigt ist, um die Vorbelastung von Federscheiben (64) einzustellen, die zwischen der lastbegrenzenden Kupplungseinrichtung (58) und dem Scheibenteil auf einer Seite desselben angeordnet sind.

10. Niederhaltevorrichtung nach Anspruch 9, dadurch gekennzeichnet, daß die Federeinrichtung (72) aus gekrümmten Federscheiben besteht, die auf der anderen Seite des einstellbaren Scheibenteils (66) angeordnet sind.

11. Niederhaltevorrichtung nach einem der Ansprüche 1 bis 10, dadurch gekennzeichnet, daß ein Axiallager (74) zwischen der Federeinrichtung (72) und der Schiebehülse (24) vorgesehen ist.

12. Niederhaltevorrichtung nach einem der Ansprüche 1 bis 11, dadurch gekennzeichnet, daß ein Ende eines Zwischenstücks (28) an einem Ende der Spindel (20) angelenkt ist und daß das andere Ende des Zwischenstücks (28) an einem festen Element (34) anlenkbar ist, das an der Rahmenvorrichtung befestigt ist.

0 071 559

FIG. 1

FIG. 2

1

FIG. 3

0 071 559

FIG. 4

FIG. 5

0 071 559

FIG. 6a

FIG. 6b

FIG. 6c

4

FIG. 7

FIG. 8

FIG. 9

5

_FIG. 10_

_FIG. 11_